# EUROPÄISCHE PATENTANMELDUNG

(11) **EP 1 111 780 A2**
(43) Veröffentlichungstag der Anmeldung: **27.06.2001**
(21) Anmeldenummer: 00204613.4
(22) Anmeldetag: 18.12.2000
(51) Int. Cl.: H03H 9/54

(54) **Filteranordnung**

(30) Priorität: 22.12.1999 DE 19962028
(71) Anmelder: Philips Corporate Intellectual Property GmbH, 52064 Aachen (DE); Koninklijke Philips Electronics N.V., 5621 BA Eindhoven (NL)
(72) Erfinder: Klee, Mareike Dr., 52064 Aachen (DE); Löbl, Hans-Peter Dr., 52064 Aachen (DE)
(74) Vertreter: Volmer, Georg, Dipl.-Ing.

(57) **Zusammenfassung**

Die Erfindung beschreibt eine Filteranordnung aus einem Bandpassfilter und einem Notch-Filter. Die Kopplung eines Notch-Filters, der aus einem Kondensator und einer Induktivität besteht, mit einem Bandpassfilter aus Resonatoren bewirkt eine bessere Unterdrückung außerhalb des Durchlassbandes.

Durch Verwendung von Dünnschichttechniken können beide Filter bei geringem Raumbedarf auf einem Substrat (1) hergestellt werden. Außerdem wird ein Sender, ein Empfangsgerät, ein Mobilfunkgerät und ein drahtloses Datenübertragungssystem mit einer solchen Filteranordnung sowie Verfahren zur Herstellung einer solchen Filteranordnung offenbart.

## Beschreibung

Die Erfindung betrifft eine Filteranordnung. Weiterhin betrifft die Erfindung noch einen Sender, einen Empfänger sowie ein Mobilfunkgerät mit einer Filteranordnung sowie ein Verfahren zur Herstellung einer Filteranordnung.

Die rasanten Entwicklungen im Mobilfunkbereich und die stete Miniaturisierung der schnurlosen Telefonapparate führen zu erhöhten Anforderungen an die einzelnen Komponenten. So ist eine hohe Selektivität im Hochfrequenzteil nötig, um den Empfänger gegen die steigende Anzahl möglicherweise störender Signale von anderen Systeme zu schützen. Dies wird beispielsweise durch Bandpassfilter erreicht, die nur ein begrenztes Frequenzband durchlassen und alle Frequenzen ober- und unterhalb dieses Bereiches unterdrücken.

Zur Zeit werden für diese Aufgabe unter anderem Filter mit keramischen, elektromagnetischen Resonatoren verwendet. Einer Miniaturisierung dieser Filter wird aber durch die elektromagnetische Wellenlänge Grenzen gesetzt. Deutlich kleiner können Oberflächen-wellen-Filter, sogenannte Surface Acoustic Wave (SAW) Filter, ausgeführt werden. Der Grund hierfür ist, dass die akustische Wellenlänge 4 bis 5 Größenordnungen kleiner ist als die elektromagnetische Wellenlänge. Nachteilig ist aber, dass Oberflächenwellen-Filter oftmals einen komplizierten Aufbau besitzen und mit Hilfe komplexer Gehäuse geschützt werden. Eine Alternative stellen Volumenwellen-Filter, die auch als Bulk Acoustic Wave (BAW) Filter bezeichnet werden, dar. Volumenwellen-Filter besitzen Vorteile in den Bereichen Größe, Leistung und IC-Kompatibilität.

In der Praxis werden durch die genannten Filter jedoch die Frequenzen, die außerhalb des Durchlassbandes liegen, nicht vollständig, sondern nur bis zu einem gewissen Grad unterdrückt. Dies kann für bestimmte Anwendung, wie zum Beispiel der Signalfilterung im Hochfrequenzteil von mobilen Telefonen oder Basisstationen, nicht ausreichend sein.

Der Erfindung liegt die Aufgabe zugrunde, einen Filter mit Bandpassfilterfunktion bereitzustellen, der eine verbesserte Unterdrückung außerhalb des Durchlassbandes aufweist.

Diese Aufgabe wird gelöst, durch eine Filteranordnung, welche ein Substrat und darauf aufgebracht einen Bandpassfilter und einen Notch-Filter, die miteinander gekoppelt sind, enthält.

Es ist vorteilhaft, dass der Notch-Filter zwischen Eingang des Bandpassfilters und Erde oder zwischen Ausgang des Bandpassfilters und Erde geschalten ist.

Durch die Kopplung des Bandpassfilters mit einem Notch-Filter kann bei einer gewünschten Frequenz eine bessere Unterdrückung im Stoppband des Bandpassfilters erreicht werden.

Es ist bevorzugt, dass der Bandpassfilter und der Notch-Filter Dünnschichtfilter sind.

Durch Ausführung der beiden Filter in Dünnschichttechnik auf einem Substrat wird eine solche Filteranordnung auf kleinen Abmessungen erhalten.

Es ist ganz besonders bevorzugt, dass der Bandpassfilter eine Filteranordnung aus Resonatoren enthält.

Es ist weiterhin bevorzugt, dass die Filteranordnung Volumenwellen-Resonatoren, Oberflächenwellen-Resonatoren oder keramische, elektromagnetische Resonatoren enthält.

Bandpassfilter, die sich aus einer Filteranordnung aus Resonatoren zusammensetzen weisen im Durchlassband geringere Verluste auf, weil sie höhere Güten Q als beispielsweise LC-Filter aufweisen. Außerdem weisen Bandpassfilter aus Resonatoren einen steileren Abfall am Rand des Durchlassbandes auf als vergleichbare LC-Kombinationen.

Es ist ganz besonders bevorzugt, dass ein Volumenwellen-Resonator eine Resonatoreinheit und ein Reflexionselement, welches zwischen Substrat und Resonatoreinheit angeordnet ist, enthält.

Ein derartiger Volumenwellen-Resonator kann mit Hilfe von Dünnschichttechniken einfach und vor allem mit geringem Raumbedarf hergestellt werden. Außerdem ist ein solcher Volumenwellen-Resonator deutlich robuster als andere Typen an Volumenwellen-Resonatoren wie Einkristall-Resonatoren, Resonatoren mit Membranen oder Resonatoren mit einem Luftspalt.

Außerdem ist es vorteilhaft, dass der Notch-Filter einen Kondensator und eine Induktivität enthält.

Ein derartiger Notch-Filter kann mit Hilfe der Dünnschichttechnologie einfach, preiswert und mit geringen Raumbedarf auf dem gleichen Substrat wie der Bandpassfilter hergestellt werden.

Desweiteren betrifft die Erfindung ein Verfahren zur Herstellung einer Filteranordnung, welche ein Substrat und darauf aufgebracht einen Bandpassfilter aus Volumenwellen-Resonatoren und einen Notch-Filter umfasst, bei dem
- auf einer Trägerschicht eine zweite Elektrode, eine piezoelektrische Schicht und eine erste Elektrode aufgebracht und so strukturiert werden, dass wenigstens eine Resonatoreinheit, ein Kondensator und eine Induktivität entstehen,
- auf den Teilen der ersten Elektrode, die zur Resonatoreinheit gehören, ein Reflexionselement abgeschieden wird,
- auf dem gesamten Aufbau ein Substrat befestigt wird und die Trägerschicht entfernt wird.

Außerdem betrifft die Erfindung einen Sender, einen Empfänger, ein Mobilfunkgerät und ein drahtloses Datenübertragungssystem ausgerüstet mit einer Filteranordnung, welche ein Substrat und darauf aufgebracht einen Bandpassfilter und einen Notch-Filter, die miteinander gekoppelt sind, enthält.

Im folgenden soll die Erfindung anhand von drei Figuren und drei Ausführungsbeispielen erläutert werden. Dabei zeigt
- Fig. 1: im Querschnitt einen Volumenwellen-Resonator des Bandpassfilter und den Notch-Filter der Filteranordnung,
- Fig. 2 bis Fig. 4: mögliche Schaltungsanordnungen einer Filteranordnung mit Bandpassfilter und Notch-Filter und
- Fig. 5: die Schaltungsanordnung einer Bandpassfilteranordnung aus Resonatoren.

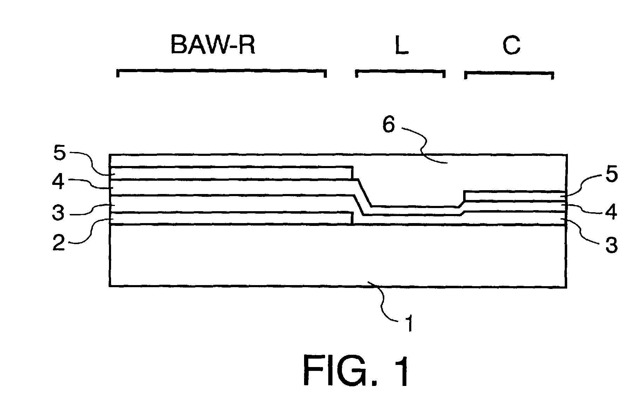

Gemäß Fig. 1 weist eine Filteranordnung mit Bandpassfilter und Notch-Filter ein Substrat 1 auf, welches zum Beispiel aus einem keramischen Material, einem keramischen Material mit einer Planarisierungsschicht aus Glas, einem glaskeramischen Material, einem Glasmaterial, Silicium, GaAs oder Saphir ist. Bei Verwendung von Silicium oder GaAs als Substrat 1 wird noch eine Passivierungsschicht aus beispielsweise SiO₂ oder Glas aufgebracht. Auf Teilen des Substrats 1 befindet sich ein Reflexionselement 2, welches eine Schicht eines Schallreflexionsstoffes aus der Gruppe der polymeren und porösen Stoffe ist. Als Schallreflexionsstoff kann beispielsweise ein Aerogel, ein Xerogel, ein Glasschaum, ein schaumartiger Klebstoff, ein Schaumstoff oder ein Kunststoff mit geringer Dichte eingesetzt werden. Als Aerogel kann zum Beispiel ein anorganisches Aerogel aus Kieselgel oder porösen SiO₂-Strukturen oder ein organisches Aerogel wie zum Beispiel ein Resorcin-Formaldehyd-Aerogel, ein Melamin-Formaldehyd-Aerogel oder ein Phenol-Formaldehyd-Aerogel verwendet werden. Als Xerogel kann beispielsweise ein anorganisches Xerogel wie hochkondensierte Polykieselsäure oder ein organisches Xerogel wie Leim oder Agar-Agar eingesetzt werden. Als Schaumstoffe können chemisch aufgeschäumte oder physikalisch aufgeschäumte Polymere wie zum Beispiel Polystyrol, Polycarbonate, Polyvinylchlorid, Polyurethane, Polyisocyanate, Polyisocyanurate, Polycarbodiimide, Polymethacrylimide, Polyacrylimide, Acryl-Butadien-Styrol-Copolymere, Polypropylene oder Polyester eingesetzt werden. Außerdem können auch geschäumte Kunstharze wie beispielsweise Phenol-Formaldehyd-Harze oder Furanharze, die durch Verkokung eine hohe Porosität besitzen, verwendet werden. Als Kunststoff mit geringer Dichte kann zum Beispiel ein vernetzter Polyvinylether, ein vernetzter Polyarylether, Polytetrafluorethylen, Poly(*p*-xylylen), Poly(2chlor-*p*-xylylen), Poly(dichlor-*p*-xylylen), Polybenzocyclobuten, ein Styrol-Butadien-Copolymer, ein Ethylen-Vinylacetat-Polymer oder ein organisches Siloxanpolymer Verwendung finden. Auf dem Reflexionselement 2 ist eine Resonatoreinheit aufgebracht, welche eine erste Elektrode 3, eine piezoelektrische Schicht 4 und eine zweite Elektrode 5 enthält. Die Elektroden 3 und 5 sind vorzugsweise aus einem gut leitenden Material mit geringer akustischer Dämpfung und können beispielsweise
Ag₁₋ₓPtₓ (0 ≤ x ≤ 1), Pt mit einer Schichtdicke von 50 nm bis 1 µm, Ti mit einer Schichtdicke von 1 bis 20 nm / Pt mit einer Schichtdicke von 20 bis 600 nm, Ti mit einer Schichtdicke von 1 bis 20 nm / Pt mit einer Schichtdicke von 20 bis 600 nm / Ti mit einer Schichtdicke von 1 bis 20 nm, Al, Al dotiert mit einigen Prozent Cu, Al dotiert mit einigen Prozent Si, Al dotiert mit einigen Prozent Mg, W, Ni, Mo, Au, Cu, Ti/Pt/Al, Ti/Ag, Ti/Ag/Ti, Ti/Ag/Ir, Ti/Ir, Ti/Pd, Ti/Ag₁₋ₓPtₓ (0 ≤ x ≤ 1), Ti/Ag₁₋ₓPdₓ (0 ≤ x ≤ 1), Ti/Pt₁₋ₓAlₓ (0 ≤ x ≤ 1), Pt₁₋ₓAlₓ (0 ≤ x ≤ 1), Ti/Ag/Pt₁₋ₓAlₓ (0 ≤ x ≤ 1), Ti/Ag/Ru, Ti/Ag/Ir/IrOₓ (0 ≤ x ≤ 2), Ti/Ag/Ru/RuOₓ (0 ≤ x ≤ 2), Ti/Ag/Ru/RuₓPt₁₋ₓ (0 ≤ x ≤ 1), Ti/Ag/Ru/RuₓPt₁₋ₓ/RuO_{y} (0 ≤ x ≤ 1, 0 ≤ y ≤ 2), Ti/Ag/Ru/RuOₓ/Ru_{y}Pt_{1-y} (0 ≤ x ≤ 2, 0 ≤ y ≤ 1), Ti/Ag/RuₓPt₁₋ₓ (0 ≤ x ≤ 1), Ti/Ag/PtₓAl₁₋ₓ (0 ≤ x ≤ 1), PtₓAl₁₋ₓ/Ag/Pt_{y}Al_{1-y} (0 ≤ x ≤ 1, 0 ≤ y ≤ 1), Ti/Ag/Pt_{y}(RhOₓ)_{1-y} (0 ≤ x ≤ 2, 0 ≤ y ≤ 1), Ti/Ag/Rh/RhOₓ (0 ≤ x ≤ 2), Ti/Ag/PtₓRh₁₋ₓ (0 ≤ x ≤ 1), Ti/Ag/Pt_{y}(RhOₓ)_{1-y}/Pt_{z}Rh_{1-z} (0 ≤ x ≤ 2, 0 ≤ y ≤ 1,0 < z ≤ 1), Ti/AgₓPt₁₋ₓ/Ir (0 ≤ x ≤ 1), Ti/AgₓPt₁₋ₓ/Ir/IrO_{y} (0 ≤ x ≤ 1, 0 ≤ y ≤ 2), Ti/AgₓPt₁₋ ₓ/Pt_{y}Al_{1-y} (0 ≤ x ≤ 1, 0 ≤ y ≤ 1), Ti/AgₓPt₁₋ₓ/Ru (0 ≤ x ≤ 1), Ti/AgₓPt₁₋ₓ/Ru/RuO_{y} (0 ≤ x ≤ 1, 0 ≤ y ≤ 2), Ti/Ag/Cr, Ti/Ag/Ti/ITO, Ti/Ag/Cr/ITO, Ti/Ag/ITO, Ti/Ni/ITO, Ti/Rh, Ti/Ru, Rh, Ti/Ni/Al/ITO, Ti/Ni, Ti/W/Ti, WₓTi₁₋ₓ (0 ≤ x ≤ 1), WₓTi₁₋ₓ/Al(Cu) (0 ≤ x ≤ 1), WₓTi₁₋ₓ/Al(Si) (0 ≤ x ≤ 1), WₓTi₁₋ₓ/Al (0 ≤ x ≤ 1) oder Ti/Cu enthalten. Als Material für die piezoelektrische Schicht 4 kann zum Beispiel AlN, ZnO, PbZrₓTi₁₋ₓO₃(0 ≤ x ≤ 1) mit und ohne Dotierungen aus La, Mn, Fe, Sb, Sr, Ni oder Kombinationen dieser Dotierungsmittel, LiNbO₃, LiTaO₃, PbNb₂O₆, Pb(Zn_{1/3}Nb_{2/3})O₃-PbTiO₃, Pb(Mg_{1/3}Nb_{2/3})O₃-PbTiO₃, Pb(Ni_{1/3}Nb_{2/3})O₃-PbTiO₃, Pb(Sc_{1/3}Nb_{2/3})O₃-PbTiO₃, Pb(Zn_{1/3}Nb_{2/3})₁₋ₓ₋ _{y}(Mn_{1/2}Nb_{1/2})ₓTi_{y}O₃ (0 ≤ x ≤ 1, 0 ≤ y ≤ 1), Pb(In_{1/2}Nb_{1/2})O₃-PbTiO₃, Sr₃TaGa₃Si₂O₁₄, K(Sr₁₋ₓBaₓ)₂Nb₅O₁₅ (0 ≤ x ≤ 1), Na(Sr₁₋ₓBaₓ)₂Nb₅O₁₅ (0 ≤ x ≤ 1), BaTiO₃, (K₁₋ₓNaₓ)NbO₃ (0 ≤ x ≤ 1), (Bi,Na,K, Pb,Ba)TiO₃, (Bi,Na)TiO₃, Bi₇Ti₄NbO₂₁, (K₁₋ₓNaₓ)NbO₃-(Bi,Na,K,Pb,Ba)TiO₃ (0 ≤ x ≤ 1), a(BiₓNa₁₋ₓ)TiO_{3-b}(KNbO_{3-c})½(Bi₂O₃-Sc₂O₃) (0 ≤ x ≤ 1, a + b + c = 1), (BaₐSr_{b}Ca_{c})TiₓZr₁₋ₓO₃ (0 ≤ x ≤ 1, a + b + c = 1), (BaₐSr_{b}La_{c})Bi₄Ti₄O₁₅ (a + b + c = 1), Bi₄Ti₃O₁₂, La₃Ga_{5.5}Nb_{0.5}O₁₄, La₃Ga₅SiO₁₄, La₃Ga_{5.5}Ta_{0.5}O₁₄ oder Polyvinylidenfluorid (PVDF) verwendet werden.

Die Elektroden 3 und 5 sowie die piezoelektrische Schicht 4 werden derart strukturiert, dass zum einen ein Bandpassfilter aus einer Anordnung von Volumenwellen-Resonatoren entsteht. Außerdem sind in einem anderen Bereich des Substrats 1 die beiden Elektroden 3,5 und die piezoelektrische Schicht 4 derart strukturiert, dass in der Nähe des Bandpassfilters ein Notch-Filter aus einer Induktivität und einem Kondensator entsteht. Der Notch-Filter ist zwischen Eingang oder Ausgang des Bandpassfilters und Erde geschaltet. Der Kondensator enthält ein Dielektrikum, welches aus der piezoelektrischen Schicht 4 gebildet wird, und die beiden Elektroden 3 und 5. Durch entsprechendes Design der ersten Elektrode 3 oder der zweiten Elektrode 5 entsteht in Serie zum Kondensator eine Induktivität.

Alternativ kann das Dielektrikum des Kondensators nicht aus der piezoelektrischen Schicht 4, sondern aus einem anderen dielektrischen Material mit einer niedrigen Dielektrizitätskonstante von 2 ≤ ε ≤ 300, wie zum Beispiel SiO₂, Si₃N₄, SiₓO_{y}N₂ (0 ≤ x ≤ 1, 0 ≤ y ≤ 1, 0 ≤ z ≤ 1), Ta₂O₅-Al₂O₃, Ta₂O₅-Nb₂O₅, Ta₂O₅-TiO₂, TiO₂ oder Ta₂O₅ gebildet werden.

Ebenso kann auch eine Elektrode des Kondensators aus einer separaten, elektrisch leitenden Schicht gebildet werden.

Über der gesamten Filteranordnung kann eine Schutzschicht 6 aus einem organischen oder einem anorganischen Material oder einer Kombination aus diesen Materialien aufgebracht sein. Als organisches Material kann beispielsweise Polybenzocyclobuten oder Polyimid und als anorganisches Material kann zum Beispiel Si₃N₄, SiO₂ oder SiₓO_{y}N_{z} (0 ≤ x ≤ 1, 0 ≤ y ≤ 1, 0 ≤ z ≤ 1) verwendet werden.

Alternativ kann das Reflexionselement 2 mehrere Schichten mit abwechselnd hoher und niedriger Impedanz enthalten. Dabei kann das Material mit niedriger Impedanz zum Beispiel ein organisches oder anorganisches Aerogel, ein organisches oder anorganisches Xerogel, ein Glasschaum, ein schaumartiger Klebstoff, ein Schaumstoff oder ein Kunststoff mit geringer Dichte sein. Als Material mit hoher akustischer Impedanz kann beispielsweise HfO₂, Mo, Au, Ni, Cu, W, Ti/W/Ti, WₓTi₁₋ₓ (0 ≤ x ≤ 1), Diamant, Ta₂O₅, Pt, Ti/Pt oder ein Kunststoff mit hoher Dichte wie beispielsweise High-Density-Polyethylen (HDPE) verwendet werden.

Wahlweise kann auch ein anderer Typ an Volumenwellen-Resonator wie zum Beispiel ein Einkristall-Resonator, ein Resonator mit Membran oder ein Resonator mit einem Luftspalt verwendet werden.

Neben Volumenwellen-Resonatoren können alternativ auch Oberflächenwellen-Resonatoren oder keramische, elektromagnetische Resonatoren verwendet werden.

Ferner kann als weitere Ausführungsform der Erfindung ein zweites Reflexionselement auf der oberen Elektrode 5 aufgebracht sein.

Eine weitere Alternative ist, dass zwischen Reflexionselement 2 und dem Substrat 1 eine zusätzliche Klebstoffschicht beispielsweise aus einem Acrylat-Klebstoff oder einem Epoxid-Klebstoff aufgebracht ist. Der Acrylat-Klebstoff kann beispielsweise Acryl- oder Methacryl-Monomere enthalten, die während des Verklebungsprozess polymerisieren.

Weiterhin kann oberhalb oder unterhalb oder ober- und unterhalb eines Reflexionselementes 2 aus porösem SiO₂ eine Schicht aus SiO2 mit einer Schichtdicke zwischen 30 und 300 nm aufgebracht sein. Diese SiO₂-Schichten, das Reflexionselement 2 und ein zweites Reflexionselement können auch über dem gesamten Bereich des Substrats 1 aufgebracht sein.

Außerdem kann die gesamte Filteranordnung mit wenigstens einer ersten und einer zweiten Stromzuführung versehen werden. Als Stromzuführung kann beispielsweise ein galvanischer SMD-Endkontakt aus Cr/Cu, Ni/Sn oder Cr/Cu, Cu/Ni/Sn oder Cr/Ni, Pb/Sn oder ein Bump-end-Kontakt oder eine Kontaktfläche eingesetzt werden.

Alternative Ausführungsformen im Aufbau und der Integration sind dem Fachmann wohlbekannt.

Eine solche Filteranordnung kann in Mobilfunkbereich und in jedem anderen Bereich der Funkübertragung (z. B. für Schnurlostelefone nach DECT oder CT, für Richt- oder Bündelfunkgeräte oder Pager), wo eine Signalfilterung benötigt wird, verwendet werden.

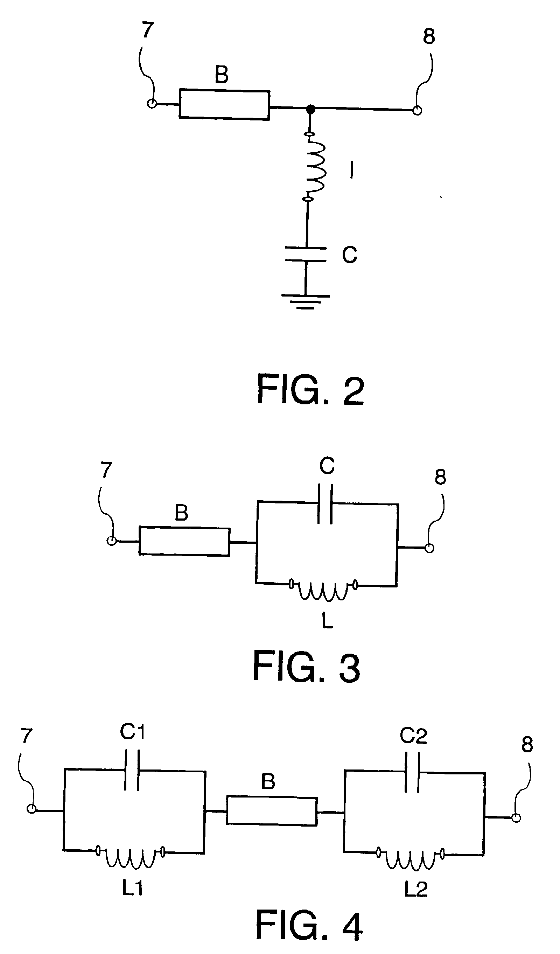

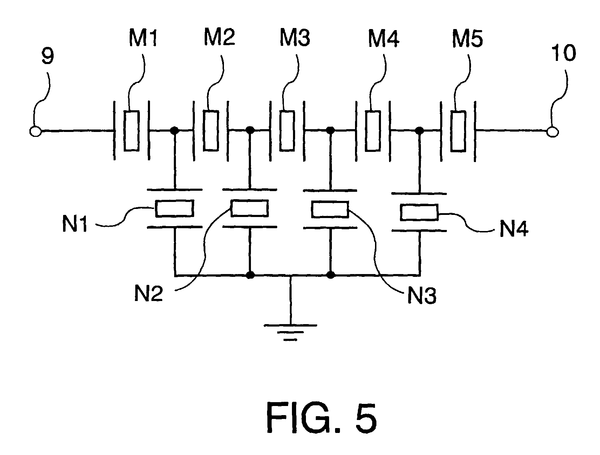

Fig. 2 zeigt eine Schaltungsanordnung einer Filteranordnung mit Bandpassfilter und Notch-Filter. Zwischen einem Eingang 7 und einem Ausgang 8 befindet sich ein Bandpassfilter B, welcher beispielsweise eine Schaltungsanordnung wie in Fig. 5 dargestellt aufweist. Der Notch-Filter, welcher eine Induktivität L und einen seriell geschalteten Kondensator C enthält, ist zwischen dem Ausgang des Bandpassfilters B und der Erde geschaltet. Der zweite Anschluss des Kondensators C liegt auf Erdpotential.

Alternativ kann die Schaltungsanordnung auch zwei oder mehrere Notch-Filter enthalten, die zwischen Eingang des Bandpassfilters B und Erde oder zwischen Ausgang des Bandpassfilters B und Erde, zwischen Ausgang und Eingang des Bandfilters B und Erde, zwischen Eingang 7 und dem Eingang des Bandfilters B oder zwischen dem Ausgang des Bandfilters B und dem Ausgang 8 geschaltet sind.

Fig. 3 zeigt eine Schaltungsanordnung einer Filteranordnung mit Bandpassfilter und Notch-Filter. Zwischen einem Eingang 7 und einem Ausgang 8 befindet sich ein Bandpassfilter B, welcher beispielsweise eine Schaltungsanordnung wie in Fig. 5 dargestellt aufweist. Der Notch-Filter, welcher eine Induktivität L und einen parallel geschalteten Kondensator C enthält, ist zwischen dem Ausgang des Bandpassfilters B und den Ausgang 8 geschaltet.

Fig. 4 zeigt eine Schaltungsanordnung einer Filteranordnung mit Bandpassfilter und zwei Notch-Filtern. Zwischen einem Eingang 7 und dem Eingang des Bandpassfilters B, welcher beispielsweise eine Schaltungsanordnung wie in Fig. 5 dargestellt aufweist, befinden sich eine Induktivität L1 und ein parallel geschaltetener Kondensator C1. Der zweite Notch-Filter, welcher eine Induktivität L2 und einen parallel geschalteten Kondensator C2 enthält, ist zwischen dem Ausgang des Bandpassfilters B und den Ausgang 8 geschaltet.

Bei diesen Schaltungsanordnungen, bei denen der Bandpassfilter B und der Notch-Filter beziehungsweise die Notch-Filter seriell geschaltet sind, kann die Induktivität L im nH-Bereich und die Kapazität im pF-Bereich gewählt werden. Damit können parasitäre Zuleitungsinduktivitäten zur Realisierung der Induktivität L genutzt werden.

Fig. 5 zeigt eine Bandpassfilteranordnung aus insgesamt neun Resonatoreinheiten M1 bis M5 sowie N1 bis N4. Zwischen einem Eingang 9 und einem Ausgang 10 sind fünf Resonatoreinheiten M1 bis M5 in Serie geschalten. Vier weitere Resonatoreinheiten N1 bis N4 sind parallel zu diesen fünf Resonatoreinheiten M1 bis M5 geschalten. Jeweils ein Anschluss der vier Resonatoreinheiten N1 bis N4 liegt auf Erdpotential. Der andere Anschluss der Resonatoreinheit N1 liegt zwischen den Resonatoreinheiten M1 und M2. Der andere Anschluss der Resonatoreinheit N2 liegt zwischen den Resonatoreinheiten M2 und M3. Der andere Anschluss der Resonatoreinheit N3 liegt zwischen den Resonatoreinheiten M3 und M4. Und der andere Anschluss der Resonatoreinheit N4 liegt zwischen den Resonatoreinheiten M4 und M5.

Eine Möglichkeit eine Filteranordnung aus Bandpassfilter und Notch-Filter herzustellen ist, dass im ersten Schritt auf einer Trägerschicht eine Resonatoreinheit, welche in umgekehrter Abfolge eine zweite Elektrode 5, eine piezoelektrische Schicht 4 und eine erste Elektrode 3 enthält, abgeschieden wird. Die Trägerschicht kann zum Beispiel aus einem keramischen Material, einem keramischen Material mit einer Planarisierungsschicht aus Glas, einem glaskeramischen Material, Silicium, GaAs oder Saphir sein. Bei Verwendung von Silicium oder GaAs in der Trägerschicht wird noch eine Passivierungsschicht aus beispielsweise SiO₂ oder Glas aufgebracht. Die Elektroden 3 und 5 sind vorzugsweise aus einem gut leitenden Material mit geringer akustischer Dämpfung und können beispielsweise Ag₁₋ₓPtₓ (0 ≤ x ≤ 1), Pt mit einer Schichtdicke von 50 nm bis 1 um, Ti mit einer Schichtdicke von 1 bis 20 nm / Pt mit einer Schichtdicke von 20 bis 600 nm, Ti mit einer Schichtdicke von 1 bis 20 nm / Pt mit einer Schichtdicke von 20 bis 600 nm / Ti mit einer Schichtdicke von 1 bis 20 nm, Al, Al dotiert mit einigen Prozent Cu, Al dotiert mit einigen Prozent Si, Al dotiert mit einigen Prozent Mg, Ni, W, Mo, Au, Cu, Ti/Pt/Al, Ti/Ag, Ti/Ag/Ti, Ti/Ag/Ir, Ti/Ir, Ti/Pd, Ti/Ag₁₋ₓPtₓ (0 ≤ x ≤ 1), Ti/Ag₁₋ₓPdₓ (0 ≤ x ≤ 1), Ti/Pt₁₋ₓAlₓ (0 ≤ x ≤ 1), Pt₁₋ₓAlₓ (0 ≤ *x* ≤ 1), Ti/Ag/Pt₁₋ₓAlₓ (0 ≤ x ≤ 1), TilAg/Ru, Ti/Ag/Ir/IrOₓ (0 ≤ x ≤ 2), Ti/Ag/Ru/RuOₓ (0 ≤ x ≤ 2), Ti/Ag/Ru/RuₓPt₁₋ₓ (0 ≤ x ≤ 1), Ti/Ag/Ru/RuₓPt₁₋ₓ/RuO_{y} (0 ≤ x ≤ 1, 0 ≤ y ≤ 2), Ti/Ag/Ru/RuOₓ/Ru_{y}Pt_{1-y} (0 ≤ x ≤ 2, 0 ≤ y ≤ 1), Ti/Ag/RuₓPt₁₋ₓ (0 ≤ x ≤ 1), Ti/Ag/PtₓAl₁₋ₓ (0 ≤ x ≤ 1), PtₓAl₁₋ₓ/Ag/Pt_{y}Al_{1-y} (0 ≤ x ≤ 1, 0 ≤ y ≤ 1), Ti/Ag/Pt_{y}(RhOₓ)_{1-y} (0 ≤ x ≤ 2, 0 ≤ y ≤ 1), Ti/Ag/Rh/RhOₓ (0 ≤ x ≤ 2), Ti/Ag/PtₓRh₁₋ₓ (0 ≤ x ≤ 1), Ti/Ag/Pt_{y}(RhOₓ)_{1-y}/Pt_{z}Rh_{1-z} (0 ≤ x ≤ 2, 0 ≤ y ≤ 1, 0 ≤ z ≤ 1), Ti/AgₓPt₁₋ₓ/Ir (0 ≤ x ≤ 1), Ti/AgₓPt₁₋ₓ/Ir/IrO_{y} (0 ≤ x ≤ 1, 0 ≤ y ≤ 2), Ti/AgₓPt₁₋ₓ/Pt_{y}Al_{1-y} (0 ≤ x ≤ 1, 0 ≤ y ≤ 1), Ti/AgₓPt₁₋ₓ/Ru (0 ≤ x ≤ 1), Ti/AgₓPt₁₋ₓ/Ru/RuO_{y} (0 ≤ x ≤ 1, 0 ≤ y ≤ 2), Ti/Ag/Cr, Ti/Ag/Ti/ITO, Ti/Ag/Cr/ITO, Ti/Ag/ITO, Ti/Ni/ITO, Ti/Rh, Ti/Ru, Rh, Ti/Ni/Al/ITO, Ti/Ni, Ti/W/Ti, WₓTi₁₋ₓ (0 ≤ x ≤ 1), WₓTi₁₋ₓ/Al(Cu) (0 ≤ x ≤ 1), WₓTi₁₋ₓ/Al(Si) (0 ≤ x ≤ 1), WₓTi₁₋ₓ/Al (0 ≤ x ≤ 1) oder Ti/Cu enthalten. Als Material für die piezoelektrische Schicht 4 kann zum Beispiel AIN, ZnO, PbZrₓTi₁₋ₓO₃ (0 ≤ x ≤ 1) mit und ohne Dotierungen aus La, Mn, Fe, Sb, Sr, Ni oder Kombinationen dieser Dotierungsmittel, LiNbO₃, LiTaO₃, PbNb₂O₆, Pb(Zn_{1/3}Nb_{2/3})O₃-PbTiO₃, Pb(Mg_{1/3}Nb_{2/3})O₃-PbTiO₃, Pb(Ni_{1/3}Nb_{2/3})O₃-PbTiO₃, Pb(Sc_{1/3}Nb_{2/3})O₃-PbTi0₃, Pb(Zn_{1/3}Nb_{2/3})₁₋ₓ₋ _{y}(Mn_{1/2}Nb_{1/2})ₓTi_{y}O₃ (0 ≤ x ≤ 1, 0 ≤ y ≤ 1), Pb(In_{1/2}Nb_{1/2})O₃-PbTi0₃, Sr₃TaGa₃Si₂O₁₄, K(Sr₁₋ₓBaₓ)₂Nb₅O₁₅ (0 ≤ x ≤ 1), Na(Sr₁₋ₓBaₓ)₂Nb₅O₁₅ (0 ≤ x ≤ 1), BaTiO₃, (K₁₋ₓNaₓ)NbO₃ (0 ≤ x < 1), (Bi,Na,K, Pb,Ba)TiO₃, (Bi,Na)TiO₃, Bi₇Ti₄NbO₂₁, (K₁₋ₓNaₓ)NbO₃-(Bi,Na,K,Pb,Ba)TiO₃ (0 ≤ x ≤ 1), a(BiₓNa₁₋ₓ)TiO_{3-b}(KNbO_{3-c})½(Bi₂O₃-Sc₂O₃) (0 ≤ x ≤ 1, a + b + c 1), (BaₐSr_{b}Ca_{c})TiₓZr₁₋ₓO₃ (0 ≤ x ≤ 1, a + b + c 1), (BaₐSr_{b}La_{c})Bi₄Ti₄O₁₅ (a + b + c = 1), Bi₄Ti₃O₁₂, La₃Ga_{5.5}Nb_{0.5}O₁₄, La₃Ga₅SiO₁₄, La₃Ga_{5.5}Ta_{0.5}O₁₄ oder Polyvinylidenfluorid (PVDF) verwendet werden. Die piezoelektrische Schicht 4 und die beiden Elektroden 3 und 5 werden derart abgeschieden und strukturiert, dass zum einen ein Bandpassfilter aus einer Anordnung von Volumenwellen-Resonatoren entsteht. Außerdem sind in einem anderen Bereich der Trägerschicht die beiden Elektroden 3,5 und die piezoelektrische Schicht 4 derart strukturiert, dass in der Nähe des Bandpassfilters ein Kondensator gebildet wird, der ein Dielektrikum aus der piezoelektrischen Schicht 4 und die beiden Elektroden 3 und 5 enthält. Durch entsprechendes Design der ersten Elektrode 3 oder der zweiten Elektrode 5 entsteht in Serie zum Kondensator eine Induktivität. Auf der ersten Elektrode 3 wird in dem Bereich, wo sich die Volumenwellen-Resonatoreinheiten befinden, ein Reflexionselement 2 aus einem Schallreflexionsstoff der Gruppe der polymeren und porösen Stoffe aufgebracht. Als Schallreflexionsstoff kann beispielsweise ein Aerogel, ein Xerogel, ein Glasschaum, ein schaumartiger Klebstoff, ein Schaumstoff oder ein Kunststoff mit geringer Dichte eingesetzt werden. Als Aerogel kann zum Beispiel ein anorganisches Aerogel aus Kieselgel oder porösen SiO₂-Strukturen oder ein organisches Aerogel wie zum Beispiel ein Resorcin-Formaldehyd-Aerogel, ein Melamin-Formaldehyd-Aerogel oder ein Phenol-Formaldehyd-Aerogel verwendet werden. Als Xerogel kann beispielsweise ein anorganisches Xerogel wie hochkondensierte Polykieselsäure oder ein organisches Xerogel wie Leim oder Agar-Agar eingesetzt werden. Als Schaumstoffe können chemisch aufgeschäumte oder physikalisch aufgeschäumte Polymere wie zum Beispiel Polystyrol, Polycarbonate, Polyvinylchlorid, Polyurethane, Polyisocyanate, Polyisocyanurate, Polycarbodiimide, Polymethacrylimide, Polyacrylimide, Acryl-Butadien-Styrol-Copolymere, Polypropylene oder Polyester eingesetzt werden. Außerdem können auch geschäumte Kunstharze wie beispielsweise Phenol-Formaldehyd-Harze oder Furanharze, die durch Verkokung eine hohe Porosität besitzen verwendet werden. Als Kunststoff mit geringer Dichte können zum Beispiel vernetzte Polyvinylether, vernetzte Polyarylether, Polytetrafluorethylen, Poly(*p*-xylylen), Poly(2-chlor-*p*-xylylen), Poly(dichlor-*p*-xylylen), Polybenzocyclobuten, Styrol-Butadien-Copolymere, Ethylen-Vinylacetat-Polymere oder organische Siloxanpolymere Verwendung finden. Auf diesem Reflexionselement 2 wird aufgrund der adhäsiven Eigenschaften des verwendeten Materials oder mittels einer zusätzlichen Klebstoffschicht, aus zum Beispiel einem Acrylat-Klebstoff oder einem Epoxid-Klebstoff, ein Substrat 1, welches aus einem keramischen Material, einem glaskeramischen Material, glaskeramischen Material mit einer Planarisierungsschicht aus Glas, einem Glasmaterial, Silicium, GaAs oder Saphir ist, befestigt. Bei Verwendung von Silicium oder GaAS als Substrat 1 wird noch eine Passivierungsschicht, beispielsweise aus SiO₂ oder Glas, aufgebracht. Anschließend wird die Trägerschicht mechanisch oder chemisch entfernt.

Bei Verwendung von PbTi₁₋ₓZrₓO₃ (0 ≤ x ≤ 1) mit und ohne Dotierungen aus La oder Mn als Material für die piezoelektrische Schicht 4 kann zwischen der Trägerschicht und zweiter Elektrode 5 eine Antireaktionsschicht aus TiO₂, Al₂O₃ oder ZrO₂ aufgebracht werden.

In einem alternativen Verfahren zur Herstellung eines erfindungsgemäßen elektronischen Bauelementes wird das Reflexionselement 2 direkt auf das gewünschte Trägersubstrat 1 abgeschieden. Anschließend wird die Resonatoreinheit aus erster Elektrode 3 und zweiter Elektrode 5 sowie der piezoelektrischen Schicht 4 aufgebracht. Das Reflexionselement 2 kann alternativ auch mehrere Schichten mit abwechselnd hoher und niedriger Impedanz enthalten.

Alternativ wird das Dielektrikum des Kondensators nicht aus der piezoelektrischen Schicht 4 gebildet, sondern es wird je nach Herstellungsverfahren eine separate Schicht aus einem dielektrischen Material mit kleiner Dielektrizitätskonstante ε von 2 ≤ ε ≤ 300, welche beispielsweise SiO₂, Si₃N₄, SiₓO_{y}N_{z} (0 ≤ x ≤ 1, 0 ≤ y ≤ 1, 0 ≤ z ≤ 1) oder Ta₂O₅ enthält, auf entsprechende Teile der ersten Elektrode 3 oder zweiten Elektrode 5 aufgebracht.

Ebenso kann eine Elektrode des Kondensators durch Abscheidung einer zusätzlichen, separaten elektrisch leitenden Schicht dargestellt werden.

In allen Fällen kann über dem gesamten Bauelement eine Schutzschicht 6 aus einem organischen oder anorganischen Material oder einer Kombination dieser Materialien aufgebracht werden. Als organisches Material kann beispielsweise Polybenzocyclobuten oder Polyimid und als anorganisches Material kann zum Beispiel Si₃N₄, SiO₂ oder SiₓO_{y}N_{z} (0 ≤ x ≤ 1, 0 ≤ y ≤ 1, 0 ≤ z ≤ 1) verwendet werden.

Alternativ kann unter- und oberhalb einer Resonatoreinheit der Filteranordnung ein weiteres Reflexionselement angebracht werden. Das weitere Reflexionselement weist entweder eine Schicht aus einem Material extrem niedriger akustischer Impedanz oder mehrere Schichten mit abwechselnd hoher und niedriger Impedanz auf.

Weiterhin kann oberhalb oder unterhalb oder ober- und unterhalb eines Reflexionselementes 2 oder eines weiteren Reflexionselementes aus porösem SiO₂ eine Schicht aus SiO₂ mit einer Schichtdicke zwischen 30 und 300 nm aufgebracht werden. Diese SiO₂-Schichten, das Reflexionselement 2 und ein zweites Reflexionselement können auch über dem gesamten Bereich des Substrats 1 aufgebracht werden.

Auf gegenüberliegenden Seiten der Filteranordnung kann wenigstens eine erste und eine zweite Stromzuführung angebracht werden. Als Stromzuführung kann beispielsweise ein galvanischer SMD-Endkontakt aus Cr/Cu, Ni/Sn oder Cr/Cu, Cu/Ni/Sn oder Cr/Ni, Pb/Sn oder ein Bump-end-Kontakt oder eine Kontaktfläche eingesetzt werden.

Im folgenden werden Ausführungsformen der Erfindung erläutert, die beispielhafte Realisierungsmöglichkeiten darstellen.

### Ausführungsbeispiel 1

Eine Filteranordnung aus Bandpassfilter und Notch-Filter wurde realisiert, in dem auf einem Substrat 1 aus Glas eine 300 nm dicke, dichte SiO₂-Schicht und darauf eine poröse SiO₂ Schicht in Form eines Aerogels als Reflexionselement 2 mit einem Klebeverfahren abgeschieden wurden. Auf diesem Reflexionselement 2 wurden neun Resonatoreinheiten, bestehend aus einer ersten Elektrode 3, einer piezoelektrischen Schicht 4 und einer zweiten Elektrode 5 aufgebracht. Die erste Elektrode 3 enthielt Pt. Die zweite Elektrode 5 enthielt eine dünne Ti-Haftschicht und eine Pt-Schicht. Die piezoelektrische Schicht 4 wies die Zusammensetzung PbZr_{0.15}Ti_{0.85}O₃ auf. Die piezoelektrische Schicht 4 und dic beiden Elektroden 3 und 5 wurden derart abgeschieden und strukturiert, dass zum einen der Bandpassfilter mit insgesamt neun Volumenwellen-Resonatoren entstand. Außerdem waren in einem anderen Bereich des Substrats 1 die beiden Elektroden 3,5 und die piezoelektrische Schicht 4 derart strukturiert, dass in der Nähe der Anordnung von Volumenwellen-Resonatoren ein Kondensator gebildet wurde, der ein Dielektrikum aus der piezoelektrischen Schicht 4 und die beiden Elektroden 3,5 enthielt. Die untere Elektrode 3 war nach Erde geschaltet. Durch Design und entsprechende Länge der ersten Elektroden 3 oder zweiten Elektrode 5 wurde in Serie zu dem Kondensator gleichzeitig eine Induktivität geschaffen. Über der gesamten Filteranordnung wurde eine Schutzschicht 6 aus SiO₂ abgeschieden. Anschließend wurden Kontaktlöcher zur Kontaktierung der ersten Elektrode 3 und der zweiten Elektrode 5 geätzt sowie Bump-end Kontakte aufgewachsen.

Ein solche Filteranordnung wurde zur Signalfilterung im Hochfrequenzteil eines mobilen Telefons eingesetzt.

### Ausführungsbeispiel 2

Zur Herstellung einer Filteranordnung mit einem Bandpassfilter und einem Notch-Filter wurde auf einer Trägerschicht aus Si mit einer Passivierungsschicht aus SiO₂ zunächst die zweite Elektrode 5 aus einer dünne Ti-Haftschicht und eine Pt-Schicht aufgebracht. Auf diese zweite Elektrode 5 wurde eine piezoelektrische Schicht 4 aus AlN aufgebracht. Anschließend wurde auf die piezoelektrische Schicht 4 eine erste Elektrode 3, welche Pt enthielt, aufgebracht. Diese drei Schichten wurden derart strukturiert, dass neun Resonatoreinheiten und ein Kondensator mit einem Dielektrikum aus AlN und den Elektroden 3,5 sowie eine Induktivität entstanden. Die untere Elektrode 3 war nach Erde geschaltet. Auf die erste Elektrode 3 wurde in dem Bereich, wo die Resonatoreinheiten waren, eine 30 nm dicke, dichte SiO₂-Schicht, darüber als Reflexionselement 2 eine poröse SiO₂-Schicht in Form eines Aerogels und auf das Reflexionselement 2 eine 300 nm dicke Schicht aus SiO₂ abgeschieden. Auf dem gesamten Aufbau wurde ein Substrat 1 aus Glas mit Acrylat-Klebstoff befestigt. Anschließend wurde die Si-Schicht der Trägerschicht weggeätzt. In die verbliebene Schicht aus SiO₂ wurden Kontaktlöcher zur Kontaktierung der ersten Elektrode 3 und zweiten Elektrode 5 geätzt. Anschließend wurden Bump-end Kontakte aus Cr/Cu in den Kontaktlöchern aufgewachsen.

Ein solche Filteranordnung wurde zur Signalfilterung im Hochfrequenzteil eines mobilen Telefons eingesetzt.

### Ausführungsbeispiel 3

Zur Herstellung einer Filteranordnung mit einem Bandpassfilter und einem Notch-Filter wurde auf einer Trägerschicht aus Si mit einer Passivierungsschicht aus SiO₂ zunächst die zweite Elektrode 5 aus einer dünnen Ti-Haftschicht und einer Pt-Schicht aufgebracht. Auf diese zweite Elektrode 5 wurde eine piezoelektrische Schicht 4 aus PbZr_{0.15}Ti_{0.85}O₃ aufgebracht. Anschließend wurde auf die piezoelektrische Schicht 4 eine erste Elektrode 3, aus Pt aufgebracht. Diese drei Schichten wurden derart strukturiert, dass zum einen neun Resonatoreinheiten entstanden. An einer Stelle neben den Resonatoreinheiten wurde durch Ätzen die zweite Elektrode 5 freigelegt. Die zweite Elektrode 5 wurde so strukturiert, dass sie als Elektrode für einen Kondensator und gleichzeitig durch Design und entsprechende Länge als Induktivität diente. Über die ganze Anordnung wurde eine 0.5 um dicke Si₃N₄ Schicht abgeschieden und so strukturiert, dass sie nur an den Stellen des Kondensators verblieb und dort als Dielektrikum diente. Auf die Si₃N₄ Schicht wurde eine separate, elektrisch leitende Schicht aus Al dotiert mit Cu aufgebracht und so strukturiert, dass sie die zweite Elektrode des Kondensators bildete. Diese zusätzliche elektrisch leitende Schicht wurde nach Erde geschaltet. Über das gesamte System wurden eine 30 nm dicke, dichte SiO₂-Schicht, auf diese SiO₂-Schicht ein Reflexionselement 2 aus einer porösen SiO₂-Schicht in Form eines Aerogels und auf das Reflexionselement 2 eine 300 nm dicke Schicht aus SiO₂ abgeschieden. Auf dem gesamten Aufbau wurde ein Substrat 1 aus Glas mit Acrylat-Klebstoff befestigt. Anschließend wurde die Si-Schicht der Trägerschicht weggeätzt. In die Schichten wurden Kontaktlöcher zur Kontaktierung der zweiten Elektrode 5 und der zusätzlichen elektrisch leitenden Schicht aus Al dotiert mit Cu geätzt. Anschließend wurden Bump-end Kontakte aus Cr/Cu in den Kontaktlöchern aufgewachsen.

Ein solche Filteranordnung wurde zur Signalfilterung im Hochfrequenzteil eines mobilen Telefons eingesetzt.

### Ausführungsbeispiel 4

Zur Herstellung einer Filteranordnung mit einem Bandpassfilter und einem Notch-Filter wurde auf einer Trägerschicht aus Si mit einer Passivierungsschicht aus SiO₂ zunächst eine elektrisch leitende Schicht aus Al dotiert mit Cu abgeschieden und elektrodenförmig strukturiert. Diese elektrisch leitende Schicht aus Al dotiert mit Cu wurde nach Erde geschaltet. Auf diese elektrisch leitende Schicht aus Al dotiert mit Cu wurde eine 0.5 um dicke Schicht aus Si₃N₄ abgeschieden. Danach wurde die zweite Elektrode 5 aus Al dotiert mit Cu aufgebracht und so strukturiert, dass sie als zweite Elektrode 5 in den Resonatoreinheiten, als Induktivität und auch als zweite Elektrode für den Kondensator diente. Auf einem Teil der zweiten Elektrode 5 wurde eine piezoelektrische Schicht 4 aus AlN aufgebracht. Anschließend wurde auf die piezoelektrische Schicht 4 eine erste Elektrode 3 aus Al dotiert mit Cu aufgebracht. Diese drei Schichten wurden derart strukturiert, dass neun Resonatoreinheiten entstanden. Das gesamte System wurde mit einer 30 nm dicken SiO₂-Schicht versehen. Auf die SiO₂-Schicht wurde als Reflexionselement 2 eine poröse SiO₂-Schicht in Form eines Aerogels und auf das Reflexionselement 2 eine 300 nm dicke Schicht aus SiO₂ abgeschieden. Auf dem gesamten Aufbau wurde ein Substrat 1 aus Glas mit Acrylat-Klebstoff befestigt. Anschließend wurde die Si-Schicht der Trägerschicht weggeätzt. In die Schichten wurden Kontaktlöcher zur Kontaktierung der zweiten Elektrode 5 und der zusätzlichen elektrisch leitenden Schicht geätzt. Anschließend wurden Bump-end Kontakte aus Cr/Cu in den Kontaktlöchern aufgewachsen.
Ein solche Filteranordnung wurde zur Signalfilterung im Hochfrequenzteil eines mobilen Telefons eingesetzt.

### Ausführungsbeispiel 5

Eine Filteranordnung aus Bandpassfilter und Notch-Filter gemäß Fig. 3 wurde realisiert, in dem auf einem Substrat 1 aus Glas eine 300 nm dicke, dichte SiO₂-Schicht und darauf eine poröse SiO₂ Schicht in Form eines Aerogels als Reflexionselement 2 mit einem Klebeverfahren abgeschieden wurden. Auf diesem Reflexionselement 2 wurden neun Resonatoreinheiten, bestehend aus einer ersten Elektrode 3, einer piezoelektrischen Schicht 4 und einer zweiten Elektrode 5 aufgebracht. Die erste Elektrode 3 enthielt Pt. Die zweite Elektrode 5 enthielt eine dünne Ti - Haftschicht und eine Pt-Schicht. Die piezoelektrische Schicht 4 wies die Zusammensetzung KNbO₃ auf. Die piezoelektrische Schicht 4 und die beiden Elektroden 3 und 5 wurden derart abgeschieden und strukturiert, daß zum einen der Bandpassfilter mit insgesamt neun Volumenwellen - Resonatoren entstand. Außerdem waren in einem anderen Bereich des Substrats 1 die beiden Elektroden 3,5 und die piezoelektrische Schicht 4 derart strukturiert, daß in der Nähe der Anordnung von Volumenwellen - Resonatoren ein Kondensator gebildet wurde, der ein Dielektrikum aus der piezoelektrischen Schicht 4 und die beiden Elektroden 3, 5 enthielt. Durch Design und entsprechende Länge der ersten Elektroden 3 oder zweiten Elektrode 5 wurde parallel zu dem Kondensator gleichzeitig eine Induktivität geschaffen. Die untere Elektrode 3 und die obere Kondensator- Elektrode 5 sind so miteinander elektrisch verbunden, daß sie als Filterausgang 8 dienen. Über der gesamten Filteranordnung wurde eine Schutzschicht 6 aus SiO₂ abgeschieden. Anschließend wurden Kontaktlöcher zur Kontaktierung der ersten Elektrode 3 und der zweiten Elektrode 5 geätzt sowie Bump - End Kontakte aufgewachsen.

Ein solche Filteranordnung wurde zur Signalfilterung im Hochfrequenzteil eines mobilen Telefons eingesetzt.

## Patentansprüche

1. Filteranordnung, welche ein Substrat (1) und darauf aufgebracht einen Bandpassfilter und einen Notch-Filter, die miteinander gekoppelt sind, enthält.

2. Filteranordnung nach Anspruch 1,
dadurch gekennzeichnet,
dass der Notch-Filter zwischen Eingang des Bandpassfilters und Erde oder zwischen Ausgang des Bandpassfilters und Erde geschalten ist.

3. Filteranordnung nach Anspruch 1,
dadurch gekennzeichnet,
dass der Bandpassfilter und der Notch-Filter Dünnschichtfilter sind.

4. Filteranordnung nach Anspruch 1,
dadurch gekennzeichnet,
dass der Bandpassfilter eine Filteranordnung aus Resonatoren enthält.

5. Filteranordnung nach Anspruch 3,
dadurch gekennzeichnet,
dass die Filteranordnung Volumenwellen-Resonatoren, Oberflächenwellen-Resonatoren oder keramische, elektromagnetische Resonatoren enthält.

6. Filteranordnung nach Anspruch 4,
dadurch gekennzeichnet,
dass ein Volumenwellen-Resonator eine Resonatoreinheit und ein Reflexionselement (2), welches zwischen Substrat (1) und Resonatoreinheit angeordnet ist, enthält.

7. Filteranordnung nach Anspruch 1,
dadurch gekennzeichnet,
dass der Notch-Filter einen Kondensator und eine Induktivität enthält.

8. Verfahren zur Herstellung einer Filteranordnung, welche ein Substrat (1) und darauf aufgebracht einen Bandpassfilter aus Volumenwellen-Resonatoren und einen Notch-Filter enthält, bei dem
- auf einer Trägerschicht eine zweite Elektrode (5), eine piezoelektrische Schicht (4) und eine erste Elektrode (3) aufgebracht und so strukturiert werden, dass wenigstens eine Resonatoreinheit, ein Kondensator und eine Induktivität entstehen,
- auf den Teilen der ersten Elektrode (3), die zur Resonatoreinheit gehören, ein Reflexionselement (2) abgeschieden wird,
- auf dem gesamten Aufbau ein Substrat (1) befestigt wird und die Trägerschicht entfernt wird.

9. Mobilfunkgerät ausgerüstet mit einer Filteranordnung, welche ein Substrat (1) und darauf aufgebracht einen Bandpassfilter und einen Notch-Filter, die miteinander gekoppelt sind, enthält.

10. Empfänger ausgerüstet mit einer Filteranordnung, welche ein Substrat (1) und darauf aufgebracht einen Bandpassfilter und einen Notch-Filter, die miteinander gekoppelt sind, enthält.

11. Sender ausgerüstet mit einer Filteranordnung, welche ein Substrat (1) und darauf aufgebracht einen Bandpassfilter und einen Notch-Filter, die miteinander gekoppelt sind, enthält.

12. Drahtloses Datenübertragungssystem ausgerüstet mit einer Filteranordnung, welche ein Substrat (1) und darauf aufgebracht einen Bandpassfilter und einen Notch-Filter, die miteinander gekoppelt sind, enthält.
